# EUROPÄISCHE PATENTSCHRIFT

(11) **EP 1 715 977 B1**
(45) Veröffentlichungstag und Bekanntmachung des Hinweises auf die Patenterteilung: **14.10.2009**
(21) Anmeldenummer: 05706673.0
(22) Anmeldetag: 10.01.2005
(51) Int. Cl.: B23K 1/018, B23K 3/08, B23K 3/06, H05K 13/04, H01L 21/60

(54) **VERWENDUNG EINES REPARATURLÖTKOPFES MIT EINEM ZUFÜHRKANAL FÜR EIN WÄRMEÜBERTRAGUNGSMEDIUM UND MIT EINEM RÜCKLAUFKANAL FÜR DIESES WÄRMEÜBERTRAGUNGSMEDIUM ZUM EINLÖTEN VON BAUTEILEN**
uSE OF A REPAIR SOLDERING HEAD HAVING SUPPLY CHANNEL FOR A HEAT TRANSFER MEDIUM AND A RETURN CHA NNEL FOR SAID HEAT TRANSFER MEDIUM FOR SOLDERING PARTS
UTILISATION D'UNE TETE DE SOUDAGE DE REPARATION COMPORTANT UN CANAL D'ALIMENTATION POUR UN FLUIDE DE TRANSFERT DE CHALEUR POUR BRASER DES PIÈCES

(30) Priorität: 21.01.2004 DE 102004003521
(43) Veröffentlichungstag der Anmeldung: 02.11.2006
(73) Patentinhaber: Rehm Thermal Systems GmbH, 89143 Blaubeuren-Seissen (DE)
(72) Erfinder: MÜLLER, Bernd, 16259 Falkenberg (DE); WITTREICH, Ulrich, 16727 Velten (DE)
(74) Vertreter: Grünecker, Kinkeldey, Stockmair & Schwanhäusser Anwaltssozietät
(86) Internationale Anmeldenummer: PCT/DE2005/000035
(87) Internationale Veröffentlichungsnummer: WO 2005/070603

(56) Entgegenhaltungen:
- DE-A1- 19 807 696
- US-A- 4 552 300
- US-A- 5 911 355
- US-A- 6 123 251
- US-B1- 6 257 478
- PATENT ABSTRACTS OF JAPAN Bd. 2003, Nr. 04, 2. April 2003 (2003-04-02) -& JP 2002 374063 A (SATO TAICHIRO), 26. Dezember 2002 (2002-12-26)
- PATENT ABSTRACTS OF JAPAN Bd. 2000, Nr. 14, 5. März 2001 (2001-03-05) -& JP 2000 315859 A (HITACHI TELECOM TECHNOL LTD), 14. November 2000 (2000-11-14)

## Beschreibung

Die Erfindung betrifft eine Verwendung eines Reparaturlötkopfs zum Einlöten von Bauelementen mit einer Aufnahme für das ein- oder auszulötende Bauelement und mit einem Zuführkanal für ein Wärmeübertragungsmedium zum Aufschmelzen des Lotes am Bauelement.

Reparaturlötköpfe der eingangs genannten Art werden beispielsweise durch die Firma ZEVAC angeboten. Dem durch diese Firma verteilten Katalog zur so genannten DRS-Modellreihe "Optionen 2.201" lässt sich der Aufbau dieser Reparaturlötköpfe auf Seite 2 entnehmen. Als Aufnahme für beispielsweise ein auszulötendes Bauelement dient eine auf die Abmessungen des Bauelementes angepasste Anlagefläche, mit der unter Zuhilfenahme eines Vakuumanschlusses das Bauteil im Reparaturlötkopf fixiert werden kann. Um diese Aufnahme herum kann ein heißes Gas durch einen Zuführkanal geblasen werden, welches nach dem Austritt aus den düsenartigen Öffnungen die Lotkontakte des Bauelementes zum Schmelzen bringt, so dass dieses mittels der Aufnahme des Reparaturltitkopfes, in der das Bauelement fixiert ist, vom Einbauort auf dem Substrat abgehoben werden kann. Der Reparaturlötkopf kann auch zum Einlöten eines Bauelementes verwendet werden, wobei zu diesem Zweck der notwendige Lotwerkstoff am einzulötenden Bauteil oder an den Kontakten des Substrates vorher bereits vorgesehen sein muss.

Unter dem Reparaturlöten im Sinne der Erfindung sollen alle Vorgänge verstanden werden, die mit dem Auslöten und anschließenden Einlöten von Bauteilen im Zusammenhang stehen.

Dabei können Teilvorgänge des Reparaturlötens auch sinnvoll beispielsweise bei der Erstmontage einzelner Bauelemente eingesetzt werden, so dass es sich hierbei nicht um das Reparaturlöten im engeren Sinne handelt.

Ein anderer Auslötkopf für Bauelemente ist in der US 4,066,204 beschrieben. Dieser Auslötkopf enthält zur Wärmeübertragung eine Heizplatte, die auf das auszulötende Bauelement gedrückt wird, so dass der Wärmeübergang durch den Kontakt zum Bauelement erfolgt.

Gemäß der DE 43 38 092 A1 ist weiterhin ein Auslötkopf für Bauelemente beschrieben, bei dem die Wärmeübertragung mit einer Heizplatte und zusätzlich mittels einer verdampften Flüssigkeit erfolgt. Die Flüssigkeit kondensiert am Ort der Wärmeübertragung, so dass die Kondensationswärme zur Erwärmung des auszulötenden Bauteils herangezogen werden kann. Das Kondensat tropft in den Vorrat zurück, und kann bei fortdauernder Erhitzung des Vorrats wieder verdampfen.

Weitere Ausführungsformen, die flüssige Lot als ein Wärmeübertragungsmedium zum Aufschmelzen der Lötverbindungen verwenden, sind aus der JP 2002-374063 A und JP 2000-315859 A bekannt. DE 198 07 696, die als nächstliegenden Stand der Technik angesehen wird, offenbart eine Verwendung eines lotkopt zum löten von bauteilen auf einem Substrate.

Die Aufgabe der Erfindung ist es, ein Verfahren zum Austauschen von Bauelementen anzugeben, mit dem das Einlöten von Bauelementen in vergleichsweise kurzer Zeit möglich ist.

Diese Aufgabe wird erfindungsgemäß gelöst durch eine Verwendung eines Reparaturlötkopfs gemäß dem Patentanspruch 1. Der verwendete Reparaturlötkopf weist dabei einen Rücklaufkanal für das flüssige Wärmeübertragungsmedium auf. Der Rücklaufkanal ermöglicht damit überhaupt erst die Verwendung eines flüssigen Wärmeübertragungsmediums, welches aufgrund seiner wesentlich höheren Dichte eine größere Wärmemenge transportieren kann als ein heißes Gas und außerdem im Vergleich zu einer Heizplatte einen optimalen Kontakt zu dem auszulötenden Bauteil herstellen kann, wodurch sich die Übertragungsgeschwindigkeit der Wärme auf das Bauelement erhöhen lässt. Daher ist vorteilhaft mittels des erfindungsgemäßen Reparaturlötkopfes unter Einsatz eines zumindest beim Rücklauf flüssigen Wärmeübertragungsmediums ein schnelles Erwärmen und damit auch schnelles Aus- bzw. Einlöten von Bauelementen möglich. Durch den beschleunigten Wärmeeintrag wird weiterhin die Umgebung des Bauelementes thermisch geringer belastet, wodurch das Einlöten und insbesondere das Auslöten zusätzlich vorteilhaft schonend für die Baugruppe erfolgen kann.

Als Wärmeübertragungsmedium wird geschmolzenes Lot verwendet. Dieses wird dem Bauelement zugeführt und tritt vor dem Erstarren wieder in den Rücklaufkanal ein.

Eine Ausführung des Reparaturlötkopfes wird dadurch erhalten, dass der Rücklaufkanal derart verläuft, dass das Wärmeübertragungsmedium in der bestimmungsgemäßen Positionierung des Reparaturlötkopfes beim Rücklaufen durch die Schwerkraft unterstützt wird. Dies bedeutet, dass der Rücklaufkanal mit Gefälle oder senkrecht nach unten verläuft, so dass das Wärmeübertragungsmedium vorteilhaft beim Rücklauf nicht unterstützt werden muss. Selbstverständlich kann der Rücklauf beispielsweise durch eine Absaugung unterstützt oder alternativ auch durch diese bewirkt werden.

Für die bestimmungsgemäße Positionierung des Reparaturlötkopfes ist es vorteilhaft, wenn dieser von unten an das ein- oder auszulötende Bauelement angenähert wird, wodurch der Rücklauf des Wärmeübertragungsmediums mit Schwerkraftunterstützung vorteilhaft besonders einfach zu realisieren ist.

Gleichzeitig wird verhindert, dass größere Rückstände an Wärmeübertragungsmedium an dem Bauelement oder im Einbauort des Substrates verbleiben.

Eine andere Ausgestaltung des verwendeten Reparaturlötkopfs sieht vor, dass der Zuführkanal und der Rücklaufkanal durch ein Innenrohr und ein dieses umgebendes Außenrohr ausgebildet sind. Innen- und Außenrohr können beispielsweise ineinander verschachtelt werden. Hierdurch ist vorteilhaft eine besonders platzsparende Gestaltung des Reparaturlötkopfes möglich. Außerdem gewährleistet die kompakte Bauform, dass möglichst wenig Wärme des Wärmeübertragungsmediums an die Umgebung abgegeben wird. Zuführ- und Rücklaufkanal können jeweils entweder als Innen- oder als Außenrohr ausgebildet sein.

Es ist vorteilhaft, wenn der Aussenkanal als Aufnahme eine Dichtkante zum ein-oder auszulötenden Bauelement hin aufweist. Diese Dichtkante stellt einerseits eine Barriere für das flüssige Wärmeübertragungsmedium dar, so dass dieses vorteilhaft besonders zuverlässig im Rückführkanal zugeführt werden kann ohne ungewollt auf angrenzende Teile der Baugruppe zu geraten. Außerdem ist vorteilhaft mit der Dichtkante eine besonders einfache Aufnahme für das Bauelement ausgebildet.

Es ist daher besonders vorteilhaft, die Aufnahme mit einer Ansaugleitung für das ein- oder auszulötende Bauelement auszustatten. Durch die Ausbildung eines Unterdruckes in der Ansaugleitung kann das Bauelement vorteilhaft zuverlässig in der Aufnahme fixiert sein. Die Wirkung der Ansaugleitung kann sich besonders gut entfalten, wenn die Ansaugleitung innerhalb der Dichtkante des Außenkanals vorgesehen wird, so dass durch die Dichtkante der Unterdruck zur Fixierung des Bauelementes mit geringem Aufwand aufrecht erhalten werden kann.

Eine besondere Ausgestaltung des Reparaturlötkopfes sieht vor, dass dieser eine mechanische Schnittstelle für eine Selektivlötanlage aufweist. Hierdurch können vorteilhaft bereits bestehende Selektivlötanlagen beispielsweise in einer Fertigungslinie von Leiterplatten genutzt werden, indem diese durch Anpassung eines geeigneten Reparaturlötkopfes erfindungsgemäß zum Reparaturlöten verwendet werden. Der Reparaturlötkopf muss dabei im Vergleich zum Lötkopf der Selektivlötanlage eine geeignete Aufnahme für das ein- oder auszulötende Bauelement aufweisen.

Das Funktionsprinzip des verwendeten Reparaturlötkopfes ermöglicht einen flexiblen Einsatz desselben beim Ein- und Auslöten von Bauelementen sowie den hierzu notwendigen vorbereitenden Fertigungsschritten. Vorteilhaft ist dabei beispielsweise die Verwendung eines Reparaturlötkopfes zum Auslöten eines Bauelementes von einem Substrat, bei der der Reparaturlötkopf mit einer Aufnahme auf einem auszulötenden Bauelement platziert wird, ein Wärmeübertragungsmedium über einen Zuführkanal auf das Bauelement geleitet wird und in flüssigem Zustand über einen Rücklaufkanal abläuft, bis die Lötverbindung zwischen dem Bauelement und dem Substrat aufgeschmolzen ist, und das Bauelement mittels der Aufnahme von dem Substrat abgehoben wird. Die Vorteile einer schnellen und zuverlässigen Erwärmung des auszulötenden Bauelementes durch das zumindest beim Rücklauf flüssige Wärmeübertragungsmedium und die daraus resultierende Verringerung der thermischen Belastung der Umgebung des Bauelementes sind bereits erläutert worden.

Weiterhin ermöglicht der beschriebene Reparaturlötkopf ein nicht beanspruchtes Entfernen von Restlot eines ausgelöteten Bauelementes, bei der der Reparaturlötkopf mit einem Zuführkanal für ein Wärmeübertragungsmedium an das Restlot angenähert wird und als Wärmeübertragungsmedium flüssiges Lot über den Zuführkanal auf das Restlot geleitet wird und im flüssigen Zustand über einen Rücklaufkanal abläuft, bis das Restlot aufgeschmolzen und zusammen mit dem Wärmeübertragungsmedium abgelaufen ist. Diese Verwendung des Reparaturlötkopfes ermöglicht vorteilhaft die Entfernung des beim Auslöten von Bauelementen gewöhnlich am Einbauplatz des Bauelementes verbleibenden Restlotes, welches das zuverlässige Einlöten eines neuen Bauelementes verhindert. Die Entfernung des Restlotes kann vorteilhaft mittels des Reparaturkopfes nach dem Auslöten des Bauelementes zwar in einem weiteren Arbeitsschritt, jedoch in der selben Positionierung des Substrates durchgeführt werden. Das zugeführte Lot schmilzt das Restlot auf, so dass dieses zuverlässig über den Rücklaufkanal abgeführt werden kann. Dabei verbleibt auf den Lotkontakten eine dünne Schicht Lotwerkstoff, die die Ausbildung neuer Lotkontakte für ein einzulötendes Bauteil vorteilhaft begünstigt. Dies ist mit der Wirkung dieser Lotschicht auf den Kontakten als Korrosionsschutz für die Kontakte zu erklären.

Gemäß einer nicht beanspruchten Verwendung des Reparaturlötkopfes zur selektiven Belotung eines Einbauplatzes für ein einzulötendes Bauelement wird Lotmaterial entsprechend der Anordnung der auszubildenden Lotverbindungen des Bauelementes auf einen Wärmeübertragungskörper aufgebracht, der Wärmeübertragungskörper in einer Aufnahme des Reparaturlötkopfes eingesetzt und mit der das Lotmaterial tragenden Seite auf dem Einbauplatz platziert wird, ein Wärmeübertragungsmedium über einen Zuführkanal auf den Wärmeübertragungskörper geleittet wird und in flüssigem Zustand über einen Rücklaufkanal abläuft, bis das Lotmaterial sich von dem Wärmeübertragungskörper löst und in dem Einbauplatz zu Lotdepots umgeschmolzen wurde und der Wärmeübertragungskörper mittels der Aufnahme ohne dass Lotmaterial von dem Substrat abgehoben wird. Hierbei kann der Reparaturlötkopf vorteilhaft auch für eine gezielte Aufbringung von neuen Lotdepots in einem lokal stark begrenzten Bereich genutzt werden. Das Verfahren, Lotkontakte mittels einer mit Lot schlecht benetzbaren Trägerplatte aufzubringen, ist aus der DE 199 23 805 C2 bereits bekannt. Als Trägerplatte wird bei der erfindungsgemäßen Verwendung der Wärmeübertragungskörper genutzt, mit dem das Lotmaterial mit hoher Präzision auf die Lotkontakte des Einbauplatzes aufgebracht werden kann, wobei die Oberseiten der so gebildeten Lotdepots vorteilhaft die Planarität der Trägerplatte aufweisen. Anschließend wird der Reparaturlötkopf verwendet, um über den Wärmeübertragungskörper genügend Wärme einzubringen, das Lotmaterial zu Lotdepots auf dem Substrat umzuschmelzen. Weitere Einzelheiten der Erfindung werden im Folgenden anhand der Zeichnung beschrieben. Hierbei zeigen
Fig. 1 ein Ausführungsbeispiel des Reparaturlötkopfes, eingebaut in eine Selektivlötanlage im Schnitt,
Fig. 2 ein weiteres Ausschnitt des Reparaturlötkopfes und
Fig. 3 ausgewählte Verfahrensschritte beim Reparaturlöten.

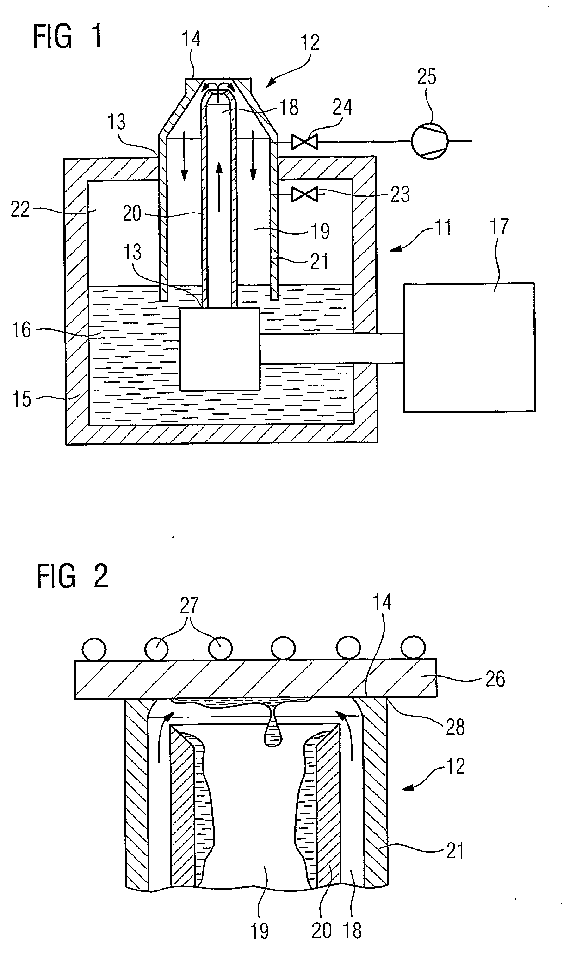

Eine Selektivlötanlage 11 gemäß Fig. 1 ist mit einem Reparaturlötkopf 12 ausgestattet. Dieser besitzt Schnittstellen 13, um in die Selektivlötanlage 11 eingebunden zu werden, in der normalerweise ein nicht dargestellter Selektivlötkopf zur Anwendung kommt. Der dargestellte Reparaturlötkopf 12 unterscheidet sich von normalen Selektivlötköpfen durch eine Aufnahme 14, die zur Halterung von Bauelementen (nicht dargestellt) geeignet ist. Daher kann der Reparaturlötkopf zum Ein- und Auslöten dieser Bauelemente beispielsweise in Leiterplatten verwendet werden. Das in einem Vorratsbehälter 15 befindliche Lot wird in dem Reparaturlötkopf 12 als flüssiges Wärmeübertragungsmedium 16 verwendet und mittels einer Pumpe 17 in einen Zuführkanal 18 des Reparaturlötkopfes 12 gepumpt. Im Bereich der Aufnahme 14 kann die Wärme des Wärmeübertragungsmediums beispielsweise zum Auslöten eines Bauelementes an dieses abgegeben werden und läuft unterstützt durch die Schwerkraft in einem Rücklaufkanal 19 zurück in den Vorratsbehälter 15. Der Fluss des Wärmeübertragungsmediums ist durch Pfeile angedeutet wobei deutlich wird, dass der Zuführkanal durch ein Innenrohr 20 ausgebildet ist, welches durch ein den Rücklaufkanal 19 bildendes Außenrohr 21 ringförmig umgeben ist.

Der obere Teil des Vorratsbehälters 15 ist mit Stickstoff 22 gefüllt. Durch einen Überdruck im Verhältnis zum Atmosphärendruck kann der Stickstoff über ein Ventil 23 und den Rücklaufkanal 19, der nicht vollständig mit dem rücklaufenden Wärmeübertragungsmedium 16 ausgefüllt ist, zur Aufnahme 14 geleitet werden, um dort eine Korrosion des flüssigen Wärmeübertragungsmediums zu verhindern. Soll das Bauelement nach dem Auslöten mittels der Aufnahme 14 des Reparaturlötkopfes 12 gehalten werden, so wird das Ventil 23 geschlossen und stattdessen das Unterdruckventil 24 geöffnet. Eine Vakuumpumpe 25 fixiert das ausgelötete Bauteil (nicht dargestellt) durch den entstehenden Unterdruck an der Aufnahme 14.

Bei dem Reparaturlötkopf 12 gemäß Figur 2 ist der Zuführkanal 18 durch das Außenrohr 21 und der Rücklaufkanal 19 durch das Innenrohr 20 gebildet. Als Wärmeübertragungsmedium wird entlang der angedeuteten Pfeile PFPE gasförmig zugeführt und kondensiert an der Oberfläche des Bauelementes 26, wodurch die in dem Wärmeübertragungsmedium gespeicherte Wärme an Lötverbindungen 27 auf der gegenüberliegenden Seite des Bauelementes 26 abgegeben wird. Das kondensierte Wärmeübertragungsmedium tropft bzw. fließt im Rücklaufkanal 19 zurück in den Vorrat an Wärmeübertragungsmedium. Um einen Verlust des gasförmigen Wärmeübertragungsmediums zu vermeiden, ist der Reparaturlötkopf mit einer an der Aufnahme 14 vorgesehenen Dichtkante 28 formschlüssig auf das Bauelement 26 aufgesetzt.

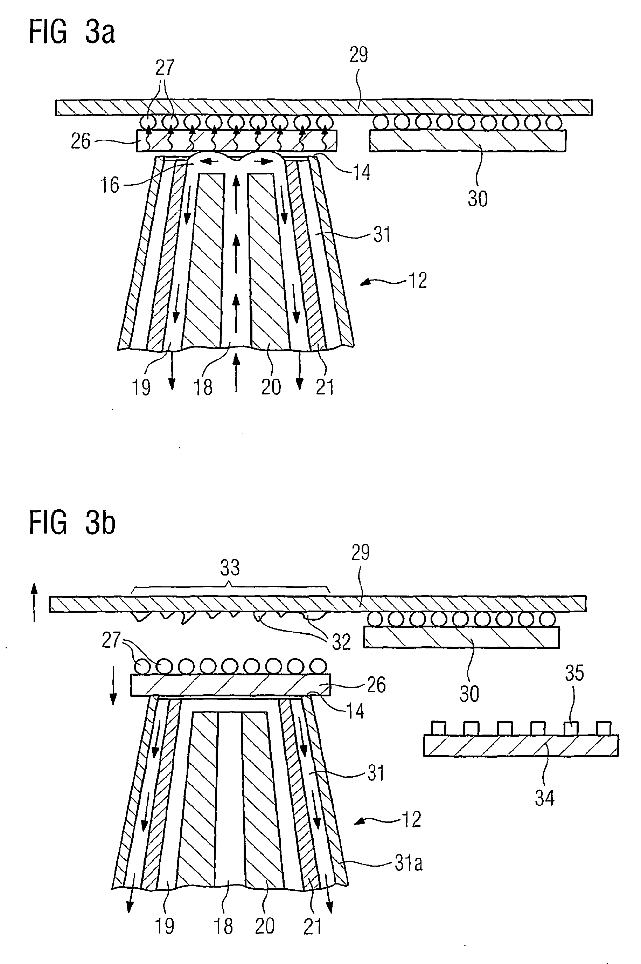

In Figur 3a ist der Reparaturlötkopf 12 während des Verfahrensschrittes des Auslötens eines Bauelementes 15 dargestellt, welches nicht Gegenstand der Erfindung ist. Über den Zuführkanal 18 wird das Wärmeübertragungsmedium 16 auf die Oberfläche des Bauelementes 26 geführt und tritt mit dieser in Kontakt. Danach wird das Wärmeübertragungsmedium 16 vor der Erstarrung über die Rücklaufkanäle 19 zurückgeleitet (angedeutet durch die geraden Pfeile). Dabei erwärmt sich das Bauelement 26 in Richtung der geschlängelten Pfeile, so dass die Lötverbindungen 27 zu einem Substrat 29 hin aufgeschmolzen werden. Dabei wird ein benachbartes Bauelement 30 auf dem Substrat 29 thermisch nur gering belastet. Sobald die Lötverbindungen 27 aufgeschmolzen sind, wird der Fluss an Wärmeübertragungsmedium 16 gestoppt.

Gemäß Figur 3b wird eine gesondert ausgeführte Ansaugleitung 31 aktiviert (gerade Pfeile), die durch ein Mantelrohr 31a um das Außenrohr 21 herum ausgebildet ist, so dass das Bauelement 15 an die Aufnahme 14 angesaugt und an dieser fixiert wird. Durch Abheben des Reparaturlötkopfes 12 von dem Substrat 29 werden die Lötverbindungen 27 getrennt, wobei auf dem Substrat eine gewisse Menge Restlot 32 verbleibt. Das Bauelement 26 kann mittels des Reparaturlötkopfes 12 einer Entsorgung zugeführt werden. Im Bereich des Restlotes 32 entsteht ein potentieller neuer Einbauplatz 33 für ein anderes Bauelement.

In der in Figur 3a dargestellten Weise erfolgt, gemäß der Erfindung, ein Einlöten eines neuen Bauelementes. Ein nicht dargestelltes, neues Bauelement wird an Stelle des Bauelementes 26 auf der Aufnahme 14 platziert, wobei vorher entweder dieses Bauelement oder der Einbausatz für das Bauelement (siehe unten) mit Lotdepots für die auszubildenden Kontakte versehen wurde. Das Umschmelzen der Lotdepots zu Kontakten erfolgt in der beschriebenen Weise durch Zuführung von Wärme in das neue Bauelement mittels des Wärmeübertragungsmediums 16.

Ein anderer Verfahrensschritt, der nicht Gegenstand der Erfindung ist, kann anhand der Figuren 3a und 3b erläutert werden, auch wenn dieser nicht gesondert dargestellt ist. Das Restlot 32 lässt sich nämlich entfernen, indem der Reparaturlötkopf 12 entsprechend Figur 3a mit dem Wärmeübertragungsmedium 16 betrieben wird und soweit an das Restlot herangeführt wird, dass dieses durch das Wärmeübertragungsmedium (welches in diesem Fall ebenfalls ein Lotwerkstoff ist) aufgeschmolzen und durch den Rücklaufkanal 19 abgeführt wird. Auf diese Weise lässt sich der Einbauplatz 33 von Restlot befreien.

Die Aufbringung von neuen Lotdepots in dem Einbauplatz als weiterer nicht dargestellter Verfahrensschritt der nicht Gegenstand der Erfindung ist, kann mittels eines Wärmeübertragungskörpers 34 erfolgen, auf den Lotmaterial 35 entsprechend der zu bildenden Lotdepots aufgedruckt ist. Der Wärmeübertragungskörper 34 kann entsprechend dem Bauelement 26 auf dem Reparaturlötkopf 12 mittels der Ansaugleitung 31 fixiert werden. Anschließend wird der Wärmeübertragungskörper entsprechend Figur 3a auf den Einbauplatz abgesenkt, wobei die Erhitzung des Wärmeübertragungskörpers 34 mittels des Wärmeübertragungsmediums 16 zu einem Umschmelzen des Lotmaterials zu Lotdepots (nicht dargestellt) im Einbauplatz 33 führt. Durch die geringe Benetzbarkeit des Wärmeübertragungskörpers verbleiben die Lotdepots bei einem anschließenden Entfernen des Wärmeübertragungskörpers 34 auf dem Substrat.

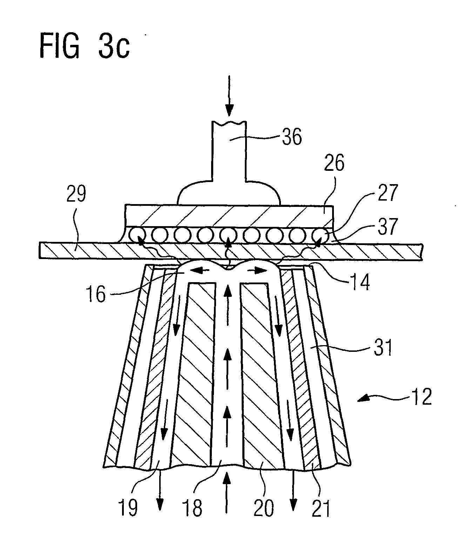

In der Figur 3c ist ein Beispiel dargestellt, das nicht Gegenstand der Erfindung ist, wie das Bauelement 26 durch eine Wärmeeinbringung entlang der geschlängelten Pfeile von der dem Bauelement 26 abgewandten Seite des Substrates 29 erfolgen kann. Das Bauelement 26 wird bei dieser Verfahrensvariante nicht durch die Aufnahme 14 des Reparaturlötkopfes 12, sondern durch ein eigens hierfür vorgesehenes Handhabungswerkzeug 36 auf das Substrat 29 aufgesetzt. Hier kann das Bauelement 26 während des Einlötens durch das Handhabungswerkzeug 36 gehalten werden. Weiterhin kann eine zusätzliche (oder alleinige) Fixierung des Bauelementes 26 durch ein preapplied underfill (37) realisiert werden.

Zur Herstellung der Lötverbindung zwischen Bauelement 26 und Substrat 29 wird mittels des Wärmeübertragungsmediums 16 im Reparaturlötkopf 12 solange Wärme in das Substrat 29 eingeleitet, bis die Lotdepots zwischen den Bauelementen 26 und dem Substrat 29 (welche auf dem Bauelement 26 oder dem Substrat 29 vorgesehen sein können) zu den dargestellten Lötverbindungen 27 umgeschmolzen werden. Anschließend kann sowohl der Reparaturlötkopf 12 als auch das Handhabungswerkzeug 36 von der montierten Baugruppe entfernt werden.

## Patentansprüche

1. Verwendung eines Reparaturlötkopfs (12) mit einer Aufnahme (14) zum Halten des ein- oder auszulötenden Bauelements (26) und mit einem Zuführkanal (18) für ein Wärmeübertragungsmedium (16) zum Aufschmelzen des Lotes (27) am Bauelement (26), und einem Rücklaufkanal (19) für das flüssige Wärmeübertragungsmedium (16) zum Einlöten des Bauelements (26) auf einem Einbauplatz (33) eines Substrates (29), bei der
- das einzulötende Bauelement in der Aufnahme (14) des Reparaturlötkopfs (12) platziert wird und auf den Einbauplatz aufgesetzt wird,
- flüssiges Lot als Wärmeübertragungsmedium (16) über den Zuführkanal (18) auf das Bauelement geleitet wird und in flüssigem Zustand über einen Rücklaufkanal (19) abläuft, bis zwischen dem Bauelement (26) und dem Substart (29) vorhandene Lotdepots zu Lötverbindungen (27) umgeschmolzen sind, und
- der Reparaturlötkopf ohne das Bauelement abgehoben wird.

## Claims

1. Use of a repair soldering head (12) with a receptacle (14) for holding a component (26) to be soldered in place or desoldered and with a feed channel (18) for a heat transfer medium (16) for melting solder (27) on the component (26), and with a return channel (19) for the liquid heat transfer medium (16) for soldering the component (26) at an installation site (33) of a substrate (29), in which
- the component to be soldered in place is positioned in the receptacle (14) of the repair soldering head (12) and is placed on the installation site,
- liquid solder is directed as heat transfer medium (16) via the feed channel (18) on to the component and drains in the liquid state via a return channel (19) until any solder deposits present between the component (26) and the substrate (29) are remelted, and
- the repair soldering head is removed without the component.

## Revendications

1. Utilisation d'une tête à souder de réparation (12), avec un logement (14) pour tenir le composant (26) à souder ou à dessouder, et avec un canal d'alimentation (18) pour un agent caloporteur (16) pour faire fondre le métal d'apport (27) au niveau du composant (26), et un canal de retour (19) pour l'agent caloporteur liquide (16) pour souder le composant (26) en un emplacement d'installation (33) d'un substrat (29), dans laquelle
- le composant à souder est placé dans le logement (14) de la tête à souder de réparation (12) et est posé à l'emplacement d'installation,
- du métal d'apport liquide est amené en tant qu'agent caloporteur (16) par l'intermédiaire du canal d'alimentation (18) sur le composant et s'écoule à l'état liquide à travers un canal de retour (19) jusqu'à ce que des dépôts de métal d'apport présents entre le composant (26) et le substrat (29) aient été transformés par fusion en soudures (27), et
- la tête à souder de réparation est enlevée sans le composant.
